Europäisches Patentamt

European Patent Office

Office européen des brevets

(11) Publication number: **0 283 023**
**A2**

# EUROPEAN PATENT APPLICATION

(21) Application number: **88104283.2**

(22) Date of filing: **17.03.88**

(51) Int. Cl.4: **H01L 39/12**

The title of the invention has been amended (Guidelines for Examination in the EPO, A-III, 7.3).

(30) Priority: **18.03.87 JP 63084/87**

(43) Date of publication of application:
**21.09.88 Bulletin 88/38**

(84) Designated Contracting States:
**DE FR GB**

(71) Applicant: **Oda, Yasukage**
**9-53, Hiyoshidai 1-bancho**
**Takatsuki-shi Osaka-fu(JP)**

Applicant: **Nakata, Ichiro**
**34-6, Hanegi 2-chome**
**Setagaya-ku Tokyo(JP)**

Applicant: **Kohara, Takao**
**1-215, Sumiyoshiyamate, 7-chome**
**Higashinada-ku Kobe-shi Hyogo-ken(JP)**

Applicant: **SUMITOMO ELECTRIC INDUSTRIES LIMITED**
**No. 15, Kitahama 5-chome Higashi-ku**
**Osaka-shi Osaka 541(JP)**

(72) Inventor: **Oda, Yasukage**
**9-53, Hiyoshidai 1-bancho**
**Takatsuki-shi, Okasa-fu(JP)**
Inventor: **Nakata, Ichiro**
**34-6, Hanegi 2-chome, Setagaya-ku**
**Tokyo(JP)**
Inventor: **Kohara, Takao**
**1-215, Sumiyoshiyamate, 7-chome,**
**Higashinada-ku**
**Kobe-shi, Hyogo-ken(JP)**

(74) Representative: **Kuhnen, Wacker & Partner**
**Schneggstrasse 3-5 Postfach 1553**
**D-8050 Freising(DE)**

(54) Ceramic superconductor.

(57) An oxide ceramics superconductor formed by a sintered body containing an element belonging to the group IIa of the periodic table such as barium or strontium, an element belonging to the group IIIa of the periodic table such as lanthanum or yttrium, copper and oxygen. The sintered body comprises a large number of crystal grains. Surfaces of the crystal grains and interfaces therebetween are formed by components which are higher in critical temperature of superconduction than those forming inner parts of the crystal grains, whereby the components showing such a high critical temperature provide three-dimensional network structure.

FIG.1

## Superconductor

BACKGROUND OF THE INVENTION

Field of the Invention

The present invention relates to a novel superconductor, and more particularly, it relates to an oxide ceramics superconductor.

Description of the Prior Art

Metal, ceramics and organic materials are generally known as those showing superconductivity, and within these, a ceramics superconductive material has been highlighted in recent years. A material being in $K_2NiF_4$ type layer perovskite structure is known as such a ceramics superconductive material. For example, an oxide ceramics superconductive material such as $[LaSr]_2CuO_4$ or $[LaBa]_2CuO_4$ shows a critical temperature of at least 30 K.

SUMMARY OF THE INVENTION

An object of the present invention is to provide an oxide ceramics superconductor, which can show a critical temperature being higher than that obtained by a conventional superconductive material of layer perovskite structure.

The present invention provides an oxide ceramics superconductor comprising a sintered body containing at least one element selected from those belonging to the group IIa of the periodic table, at least one element selected from those belonging to the group IIIa of the periodic table, copper and oxygen, in which surfaces of crystal grains and interfaces therebetween are formed by components being higher in critical temperature of superconduction than those forming inner parts of the crystal grains so that the higher critical temperature components provide three-dimensional network structure.

The aforementioned wording "surfaces of crystal grains" is directed to a concept including not only those forming the surface of the sintered body itself but also those being in contact with a large number of pores defined in the sintered body, whether such pores communicate with the exterior or not. Further, the wording "interfaces between the crystal grains" is directed to boundaries between adjacent pairs of crystal grains which are different in crystal orientation from each other.

An oxide ceramics superconductor comprising a sintered body according to the present invention is provided therein with higher critical temperature components forming three-dimensional network structure, whereby a large amount of lines of magnetic flux (fluxoid) can be taken in the network in correspondence to artificial formation of vortex filaments, to provide an extremely high critical magnetic field $(Hc_2)$.

The three-dimensional network structure can be recognized as aggregate structure of fine or thin materials respectively being in the form of filaments or sheets, whereby a large number of superconduction-normal conduction interfaces are provided to increase the critical temperature (Tc) as compared with that in the so-called bulk state.

According to the Anderson model by Dr. P. W. Anderson, who theoretically proposed a mechanism of a ceramics oxide superconductor, for example, it can be considered that inter-electron attraction is easily caused by magnetic interaction between electron spins as dimensionality of substances is reduced, thereby to easily generate electron pairs. It can be inferred on the basis of such theory that the three-dimensional network structure according to the present invention is increased in critical temperature since the same is formed by higher critical temperature components being in the form of filaments or sheets, to be in low dimensionality.

These and other objects, features, aspects and advantages of the present invention will become more apparent from the following detailed description of the present invention when taken in conjunction with the accompanying drawings.

BRIEF DESCRIPTION OF THE DRAWINGS

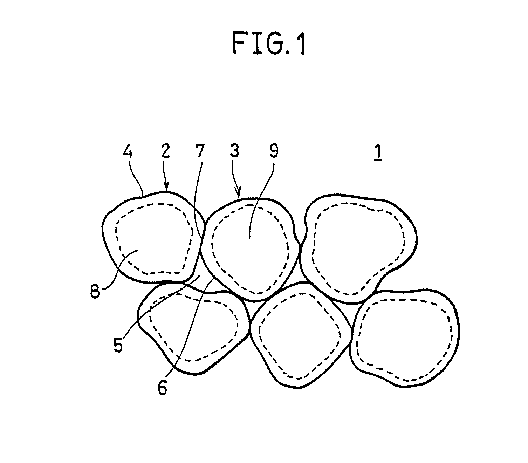

Fig. 1 is a model view showing crystal grains which are present in a superconductor according to the present invention.

DETAILED DESCRIPTION OF THE INVENTION

Referring to Fig. 1, a superconductor 1 is provided therein with a large number of crystal grains 2, 3, ..., which are in contact with each other. The crystal grains 2, 3, ... have surface parts 4 forming the surface of a sintered body itself as well as surface parts 6 which are in contact with pores 5 defined in the interior of the sintered body. Assuming that the crystal grain 2 is different in crystal orientation from the crystal grain 3, an interface 7 is defined in the boundary between the same.

With reference to Fig. 1, the surface parts 4 and 6 of the crystal grains 2 and 3 and the interface 7 between the same are formed by components being higher in critical temperature of superconduction than those forming inner parts 8 and 9 of the crystal grains 2 and 3 according to the present invention, so that the higher critical temperature components provide three-dimensional network structure.

The higher critical temperature components providing the three-dimensional network structure are distributed in prescribed depth from the surface parts 4 and 6 of the crystal grains 2 and 3 and the interface 7 therebetween in practice, as shown by dotted lines in Fig. 1.

The aforementioned elements belonging to the group IIa of the periodic table are Be, Mg, Ca, Sr, Ba and Ra. The elements belonging to the group IIIa of the periodic table are Sc, Y, La, Ac, Ce, Pr, Nd, Pm, Sm, Eu, Gd, Tb, Dy, Ho, Er, Tm, Yb and Lu. Preferably, barium or strontium is selected from the elements belonging to the group IIa while lanthanum, yttrium or scandium is selected from the elements belonging to the group IIIa.

In addition, a part of the group IIa elements may be replaced by elements exhibiting valence of $+2$, while a part of the group IIIa elements may be replaced by elements exhibiting valence of $+3$.

In order to obtain a sintered body for forming the superconductor according to the present invention, mixed powder containing barium, yttrium and copper was fired in the air to provide a sintered body having a black surface with metallic luster appearing in depth of 0.1 to 0.5 mm from the surface. It can be inferred that such a black surface part having metallic luster resulted from sintering under specific oxygen partial pressure, while it has been confirmed that the substances forming such a surface part of the sintered body importantly contributed to increase in critical temperature of superconduction. It can be inferred that presence of oxygen is important in order to increase the critical temperature of superconduction as obvious from the above description.

It has been also confirmed that a firing temperature for obtaining a sintered body for forming the superconductor according to the present invention is preferably selected to be not more than a lower one of a melting temperature and a decomposition temperature of the material to be fired and at least a temperature capable of sintering. The wording "melting temperature" indicates that causing the smallest possible liquid phase in firing. The wording "decomposition temperature" indicates that at least partially causing separation in the units of elements or components, to disable provision of crystal structure. It is pointed out here that relation between the "melting temperature" and the "decomposition temperature" is varied with material components, composition ratios and the like, and it is impossible to uniformly decide which one is at a higher value. The aforementioned firing temperature is more preferably selected to be immediately under the lower one of the melting temperature and the decomposition temperature. It has been confirmed that a larger amount of higher critical temperature parts can be obtained by selecting the firing temperature between the lower one of the melting and decomposition temperatures and a temperature lower by 30°C than the said temperature, for example.

Further study has been made on superconductivity of the inventive sintered body, other electromagnetic properties, thermal properties such as specific heat, physico-chemical properties such as specific gravity and X-ray structural analysis and mechanical properties such as Vickers surface hardness, to obtain the following views:

For example, while extremely large amounts of substances of excellent superconductivity were present in portions of about 0.5 mm in depth from surfaces of crystal grains as hereinabove described, it has been confirmed that, in more essential terms, such substances were generated on surfaces of crystal grains which were sintered under an atmosphere containing oxygen such as the atmospheric air. It has been further confirmed that substances of excellent superconductivity were present in portions deeper than the aforementioned portions of 0.5 mm in depth although the amounts thereof were small, since the superconductor according to the present invention was formed by a sintered body having fine pores in its interior. Thus, it may be considered that larger amounts of substances of excellent superconductivity were generated on the surfaces parts since new oxygen was continuously supplied to the surface of the sintered body with prescribed partial pressure.

Thus, it has been clarified that surfaces of crystal grains and interfaces between the same are important factors for deciding electric resistance, and superconductive current ultimately flows in portions of three-dimensional network structure in the surfaces of the crystal grains and the interfaces between the same, which are formed by components being higher in critical temperature of superconduction than those forming the inner parts of the crystal grains.

DESCRIPTION OF THE PREFERRED EMBODIMENTS

As Example of the present invention, a sample was obtained to be finally in composition of $BaCu_{0.7}Y_{0.3}O_3$ by compacting fine powder containing oxides of Ba, Y and Cu under 1000 atm. and firing the same in the atmosphere at 940°C for 24 hours.

This sample was subjected to examination of variation in electric resistance caused by temperature change, to confirm that three inflection points appeared in electric resistance change such that a first inflection point was around 100 K and the second inflection point was around 200 K while the third inflection point was around 300 K. A complete superconductive state was attained at about 82 K.

With respect to the aforementioned three inflection points in electric resistance, it can be inferred that the higher critical temperature components forming the surfaces of the crystal grains and the interfaces therebetween, being distributed in large amounts in the portions close to the surface of the sintered body, contribute to the third inflection point appearing at the highest temperature.

The fact that the substances forming the surfaces of the crystal grains and the interfaces therebetween have such high critical temperature that a superconductive state is attained in proximity to a normal temperature around 300 K has been confirmed as follows:

A sample obtained in bulk in the aforementioned manner was ground in depth of 0.5 mm from the surface, whereby the amounts of the substances contributing to the aforementioned extremely high critical temperature were so reduced that the said high critical temperature could not be identified, although the result of X-ray structural analysis was substantially unchanged. It has been suggested as the result that the highest critical temperature was mainly provided by the substances generated in portions of 0.5 mm in depth from the surface of the sintered body, which substances were continuously supplied with new oxygen to form the surfaces of the crystal grains and the interfaces therebetween.

The fact that the substances providing the highest critical temperature are formed in larger amounts in the portions close to the surface of the sintered body can also be confirmed by measurement of the magnetization factor. Although a Meissner effect ought be recognized from a point called "Tc on set" where reduction in electric resistance starts in a substance showing a uniform superconductive phenomenon entirely over the bulk, such Meissner effect started to appear after electric resistance completely reached zero in the sample obtained in the aforementioned manner. This suggests that the substances providing the highest critical temperature were distributed in larger amounts in the portions close to the surface of the sintered body.

It has also been confirmed through measurement that this sample had an extremely high critical magnetic field ($H_{c2}$) in excess of 100 T.

Although the present invention has been described and illustrated in detail, it is clearly understood that the same is by way of illustration and example only and is not to be taken by way of limitation, the scope of the present invention being limited only by the terms of the appended claims.

**Claims**

1. An oxide ceramics superconductor formed by a sintered body containing at least one element selected from those belonging to the group IIa of the periodic table, at least one element selected from those belonging to the group IIIa of the periodic table, copper and oxygen and comprising aggregate structure of a large number of crystal grains,

surfaces of said crystal grains and interfaces therebetween being formed by components being higher in critical temperature of superconduction than those forming inner parts of said crystal grains, said high critical temperature components providing three-dimensional network structure.

2. A superconductor in accordance with claim 1, wherein said element belonging to the group IIa of the periodic table is barium or strontium, and said element belonging to the group IIIa of the periodic table is lanthanum, yttrium or scandium.

# FIG.1